# EUROPEAN PATENT APPLICATION

(11) **EP 4 432 317 A1**
(43) Date of publication of application: **18.09.2024**
(21) Application number: 23162470.1
(22) Date of filing: 16.03.2023
(51) Int. Cl.: H01F 27/28, H01F 27/40, H01L 23/52, H01L 23/64, H05K 1/16, H05K 1/18

(54) **TRANSFORMER ARRANGEMENT**

(71) Applicant: Infineon Technologies Austria AG, 9500 Villach (AT)
(72) Inventor: THEUSS, Horst, 93173 Wenzenbach (DE); GEIßLER, Christian, 93356 Teugn (DE); HARTNER, Walter, 93077 Bad Abbach (DE)
(74) Representative: Westphal, Mussgnug & Partner, Patentanwälte mbB

(57) **Abstract**

A transformer arrangement is disclosed. The transformer arrangement includes: an electrically insulating carrier (1); a first integrated circuit (2) including a first semiconductor die (20) embedded in or arranged on top of the electrically insulating carrier (1); and a transformer (3) including a first winding (31) and a second winding (32) that are inductively coupled. One of the first and second windings (31, 32) is connected to the first integrated circuit (2), and each of the first and second windings (31, 32) is embedded in or arranged on top of the electrically insulating carrier (1).

## Description

This disclosure relates in general to a transformer arrangement, in particular a transformer arrangement including a coreless transformer.

In many types of electronic circuits a galvanic decoupling (galvanic isolation) is required between electronic circuits or devices, such as between a control circuit and an electronic device or circuit controlled by the control circuit. A galvanic isolation may be used for safety reasons in order to prevent that a high-voltage occurring at the electronic circuit or device may occur at the control circuit. A galvanic isolation may also be used in those cases in which a reference potential of the electronic device or circuit is significantly different from a reference potential of the control circuit. The latter may occur, for example, in an electronic circuit in which the electronic device controlled by the control circuit is a high-side switch.

A galvanic isolation between the control circuit and the electronic device or circuit controlled by the control circuit may be achieved using a transformer, which may also be referred to as magnetic or inductive coupler. In addition to the transformer, a transformer arrangement providing galvanic isolation between electronic circuits or devices may include a transmitter circuit and a receiver circuit. The transmitter circuit is connected to a first winding of the transformer, is configured to receive an input signal, and is configured to transmit the information included in the input signal across the transformer. The receiver circuit is connected to a second winding of the transformer, and is configured to generate an output signal that corresponds to the input signal received by the transmitter circuit. The transmitter circuit may use conventional modulation techniques in order to generate, based on the input signal, a transmission signal suitable to be transmitted across the transformer. The receiver circuit uses a corresponding demodulation technique in order to retrieve the output signal from the received transmission signal.

Each of the transmitter circuit and the receiver circuit can be implemented as an integrated circuit, wherein the transformer and at least one of the transmitter circuit and the receiver circuit may be arranged in an integrated circuit package. The package mechanically protects the transformer and the transmitter circuit and/or the receiver circuit and can be mounted on a printed circuit board (PCB).

In order to save space, the transformer may be formed on top of a semiconductor chip (semiconductor die) that includes the transmitter circuit or the receiver circuit. In order to achieve a reliable signal transmission across the transformer a certain size of the transformer windings is required, so that a minimum size of the semiconductor die on top of which the transformer is arranged is given by the desired size of the transformer, even though technology would allow to shrink the semiconductor die.

There is a need for a transformer arrangement with a transformer and at least one integrated circuit that can be implemented in a space-saving fashion.

One example relates to a transformer arrangement. The transform arrangement includes an electrically insulating carrier, a first integrated circuit, and a transformer. The first integrated circuit includes a first semiconductor die embedded in or arranged on top of the electrically insulating carrier, and the transformer includes a first winding and a second winding that are inductively coupled. One of the first and second windings is connected to the first integrated circuit, and each of the first and second windings is embedded in or arranged on top of the electrically insulating carrier.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates one example of a transformer arrangement that includes an electrically insulating carrier, a transformer, and a first integrated circuit;
Figure 2 illustrates an equivalent circuit diagram of the transformer arrangement according to Figure 1;
Figure 3 illustrates a wafer that includes a plurality of electrically insulating carriers each including a transformer (not illustrated) and a first integrated circuit (not illustrated);
Figure 4 illustrates a modification of the transformer arrangement according to Figure 1 that further includes a second integrated circuit;
Figure 5 illustrates an equivalent circuit diagram of the transformer arrangement according to Figure 1;
Figures 6A-6B illustrates one example of a package that includes a package body in which the electrically insulating carrier is embedded;
Figures 7A-7B illustrates another example of a package;
Figure 8 illustrates an example of a transformer arrangement that includes a further integrated circuit arranged in the same package as the electrically insulating carrier;
Figure 9 illustrates an equivalent circuit diagram of the transformer arrangement according to Figure 7;
Figure 10 illustrates a vertical cross-sectional view of the electrically insulating carrier according to one example;
Figures 11A-11B illustrate a top view of first and second windings embedded in the electrically insulating carrier according to Figure 10;
Figures 12-22 illustrate vertical cross-sectional views of electrically insulating carriers according to further examples;
Figure 23 illustrates a vertical cross-sectional view of an electrically insulating carrier in which first and second windings of the transformer are arranged in the same horizontal plane of the electrically insulating carrier;
Figure 24 shows a top view of the first and second windings according to Figure 23;
Figure 25 illustrates a transformer arrangement according to another example that includes an integrated circuit and a transformer spaced apart from the integrated circuit:
Figures 26A-26B illustrate vertical cross-sectional views of the transformer according to Figure 25;
Figure 27 illustrates another example of the transformer; and
Figures 28A-28B illustrated a transformer according to yet another example.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

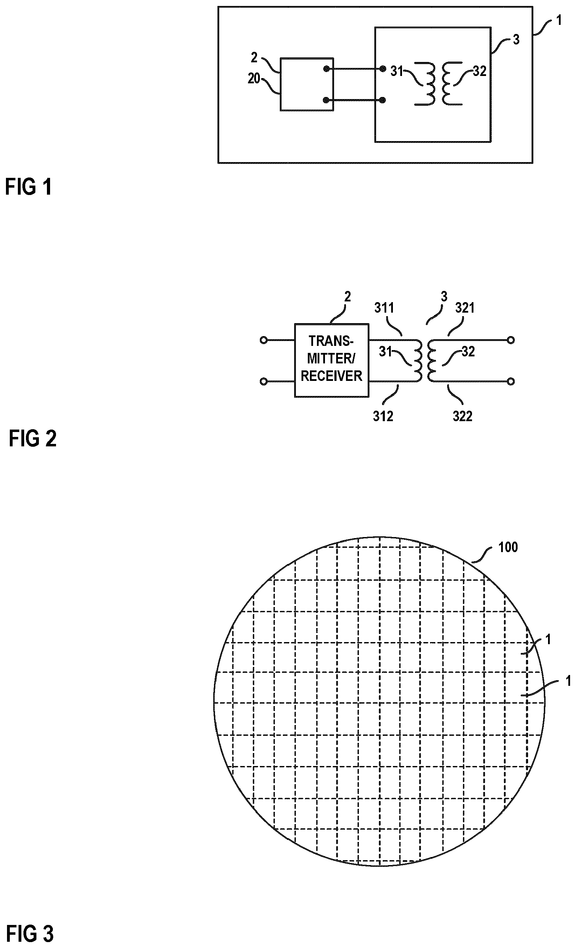

Figure 1 schematically illustrates one example of a transformer arrangement. The transform arrangement includes an electrically insulating carrier 1, a first integrated circuit 2, and a transformer 3. The first integrated circuit 2 includes a first semiconductor die 20. The first semiconductor die 20 is embedded in the electrically insulating carrier 1 or is arranged on top of the electrically insulating carrier 1. Examples for embedding the first semiconductor die 20 in the electrically insulating carrier 1 or for arranging the first semiconductor die 20 on top of the electrically insulating carrier 1 are explained in detail herein further below.

According to one example, the electrically insulating carrier 1 includes at least one of a mold compound; a glass; a polyimide; an epoxy; an oxide, such as silicon oxide; a nitride, such as silicon nitride; or a ceramic, in particular a high-k ceramic, such as BaTiOx, AlOx, or the like.

Referring to Figure 1, the transformer 3 includes a first winding 31 and a second winding 32 that are inductively coupled. Each of the first and second windings 31, 32 is embedded in or arranged on top of the electrically insulating carrier 1, and one of the first and second windings 31, 32 is connected to the first integrated circuit 2. The first and second windings 31, 32 are only schematically illustrated in Figure 1. Examples for implementing the first and second windings 31, 32 and for embedding the first and second windings 31, 32 in the electrically insulating carrier 1 or arranging the first and second winding said 31, 32 on top of the electrically insulating carrier 1 are explained in detail herein further below.

According to one example, the transformer 3 is a coreless transformer. A "coreless transformer" is a transformer that does not include a magnetic core.

Figure 2 shows an equivalent circuit diagram of an electronic circuit that includes a transformer arrangement of the type illustrated in Figure 1. In this example, the first integrated circuit 2 includes a at least one of a transmitter circuit and a receiver circuit and is connected to the first winding 31. For this, the first winding 31 includes a first terminal 311 and a second terminal 312 wherein both the first terminal 311 and the second terminal 312 are connected to the integrated circuit 2. The second winding 32 is inductively coupled with the first winding 31 and includes a first terminal 321 and a second terminal 322.

In the transformer arrangement according to Figure 1, the first integrated circuit 2 and the transformer 3 can be designed independently. Different from conventional transformer arrangements in which, for example, the transformer is formed on top of the integrated circuit a shrink of the integrated circuit is possible without affecting the size of the transformer. Moreover, the electrically insulating carrier 1 provides for an electric isolation between the transformer 3 and the first integrated circuit 2, wherein an electrical connection between one of the first and second windings 31, 32 and the first integrated circuit 2 is provided by respective conductors, which are only schematically illustrated in Figure 1. Such conductors may be embedded in the electrically insulating layer 1 or formed on top of the electrically insulating layer 1.

The transformer arrangement 1 according to Figure 1 with the electrically insulating carrier 1 carrying the first integrated circuit 2 and the transformer 3 may be handled and packaged in the same way as a single conventional semiconductor die. A plurality of transformer arrangements 1 may be manufactured at the same time in a wafer 100 that includes a plurality of transformer arrangements 1 of the same type.

One example of a wafer of this type is illustrated in Figures 3. Referring to Figure 3, the wafer includes a plurality of transformer arrangements 1 that are manufactured at the same time and that each include an electrically insulating carrier 1, a transformer and an integrated circuit. In Figure 3, only the electrically insulating carriers 1 are schematically illustrated. After forming the wafer with the plurality of transformer arrangements 1, the wafer 100 can be subdivided by cutting the wafer along cutting lines (illustrated in dashed lines in Figure 3) in order to obtain a plurality of transformer arrangements 1 of the type illustrated in Figure 1.

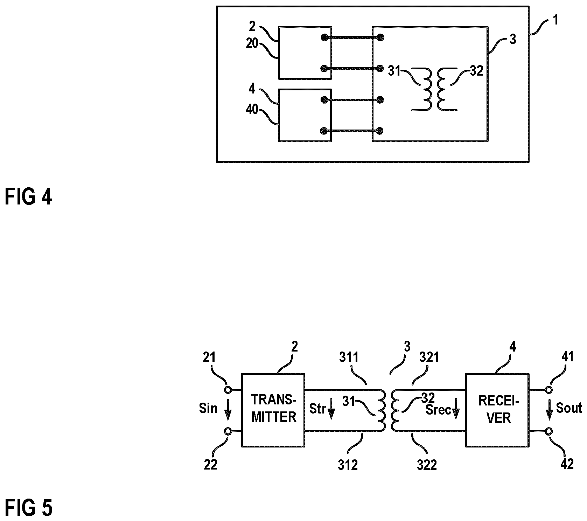

Figure 4 illustrates a modification of the transformer arrangement 1 according to Figure 1. In addition to the first integrated circuit 2 and the transformer 3, the transformer arrangement 1 according to Figure 4 includes a second integrated circuit 4. The second integrated circuit 4 includes a second semiconductor die 40 that is embedded in the electrically insulating layer 1 or is formed on top of the electrically insulating layer 1. Referring to the above, one of the first and second windings 31, 32 is electrically connected to the first integrated circuit 2. According to one example, in the transformer arrangement 1 according to Figure 4, the other one of the first and second windings 31, 32 is connected to the second integrated circuit 4. Electrical connections that connect the first winding 31 to the first integrated circuit 2 and the second winding 32 to the second integrated circuit 4 our only schematically illustrated in Figure 4.

Figure 5 shows an equivalent circuit diagram of an electronic circuit that includes a transformer arrangement 1 of the type illustrated in Figure 4. In the electronic circuit according to Figure 5, the first integrated circuit 2 includes a transmitter that is connected to the first winding 31. More specifically, the transmitter is connected to the first and second terminals 311, 312 of the first winding 31. Furthermore, in the electronic circuit according to Figure 5, the second integrated circuit 4 includes a receiver that is connected to the second winding 32. More specifically, the receiver is connected to first and second terminals 321, 322 of the second winding 32.

The electronic circuit according to Figure 5 may be used to transmit an input signal Sin received at a port 21, 22 of the transmitter (included in the first integrated circuit 2) across the transformer 3 and provide an output signal Sout corresponding to the input signal Sin at a port 41, 42 of the receiver 4. "Corresponding to" in this context includes that information included in the input signal Sin can be derived from the output signal Sout. According to one example, the input signal Sin is a digital data signal including a sequence of logic 1s and 0s, so that the output signal Sout is also a digital data signal that includes the same sequence of 1s and 0s. According to another example, the input signal Sin is a PWM signal with a certain frequency and a duty cycle. In this example, the output signal Sout is also a PWM signal with the same frequency and duty cycle as the input signal Sin.

Referring to Figure 5, transmitting the input signal Sin includes generating a transmitter signal Str by the transmitter based on the input signal Sin. The transmitter signal Str is a signal that is suitable to be transmitted across the transformer 3 and is provided to the first winding 31. The transmitter included in the first integrated circuit 2 may modulate the information included in the input signal Sin onto the transmitter signal Str. The modulation may include frequency modulation, amplitude modulation, or the like. At the second winding 32 a receiver signal Srec is available that is dependent on the transmitter signal Str. The receiver 4 is configured to demodulate the receiver signal Srec in order to obtain the output signal Sout. This way of transmitting a signal across a transformer is commonly known, so that no further explanation is required in this regard.

In the electronic circuit according to Figure 5, the transformer 3 provides for a galvanic isolation between the first and second integrated circuits 2, 4.

The electronic circuit according to Figure 5 is a unidirectional circuit. That is, this circuit is capable of transmitting a signal received at the input 21, 22 of the first integrated circuit 2 across the transformer 3 to the output 41, 42 of the second integrated circuit number 4. This, however, is only an example. According to another example, a transceiver circuit is integrated both in the first integrated circuit 2 and the second integrated circuit 4. In this example, the electronic circuit is capable of transmitting a signal received at the port 21, 22 of the first integrated circuit 2 to the port 41, 42 of the second integrated circuit 4 and is also capable of transmitting a signal received at the port 41, 42 of the second integrated circuit 4 to the port 21, 22 of the first integrated circuit 2.

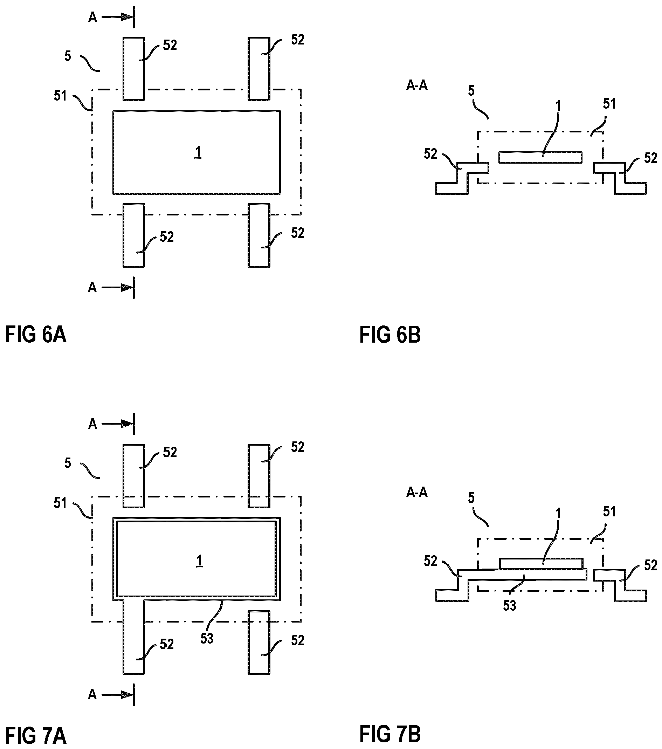

According to one example, the transformer arrangement further includes a package 5 with a package body 51. In this example, the electrically insulating carrier 1 with the transformer 3 and at least the first semiconductor die 2 is embedded in the package body 51. The package body 51 may include a mold compound. One example of a transformer arrangement that includes a package 5 is illustrated in Figures 6A-6B.

Figure 6A shows a top view of a transformer arrangement that includes a package 5 with a package body 51 and the electrically insulating layer 1 embedded in the package body 51, and Figure 6B shows a vertical cross-sectional view of the package 5 in a section plane A-A illustrated in Figure 6A. Figures 6A-6B show the package body 51 in a transparent fashion, so that the position of the insulating carrier 1 within the package body 51 is visible. Furthermore, Figures 6A-6B only illustrate the electrically insulating carrier 1. The transformer 3, the first semiconductor die 2 and, optionally, the second semiconductor die 4 that are embedded in the electrically insulating carrier 1 or arranged on top of the electrically insulating carrier 1 are not illustrated.

In addition to the package body 51 the package may include a plurality of legs each protruding from the package body 51. In the following, the first integrated circuit 2, the transformer 3 and the optional second integrated circuit 4 are referred to as "components" carried by the electrically insulating carrier 1. Each of the legs 52 is connected to a respective terminal of one of the components carried by the electrically insulating carrier 1. In this way, the legs 52, which are accessible outside the package 5, provide connections to the components. It should be noted that connections between the legs 52 and the components are not illustrated in Figures 6A-6B. Such connections may include bond wires, clips, or the like.

Just for the purpose of illustration, four legs 52 are illustrated in Figure 6A. This, however, is only an example. The number of legs 52 is dependent on the specific implementation of the transformer arrangement and equals the number of terminals of the transformer arrangement that are to be accessed from outside the package 5.

In the example illustrated in Figures 6A-6B, the electrically insulating carrier 1 is completely embedded in the package body 51. This includes, that each surface of the electrically insulating carrier 1 is covered by the package body 51. This, however, is only an example. According to another example (not illustrated) a surface of the electrically insulating carrier 1 is not covered by the package body 51. This helps to reduce, the thermal resistance for carrying heat away from the electrically insulating carrier 1.

Figures 7A-7B show a modification of the transformer arrangement according to Figures 6A-6B. Figure 7A shows a top view and Figure 7B shows a vertical cross-sectional view of the transformer arrangement. In this example, the package 5 further includes a leadframe 53 that is connected to one of the legs 52 and that carries the electrically insulating carrier 1. Referring to Figures 7A-7B, the leadframe 53 and the electrically insulating carrier 1 may completely be embedded in the package body. According to another example (not illustrated) a surface of the leadframe 53 that faces away from the electrically insulating carrier 1 is not covered by the package body 51. This reduces the thermal resistance for carrying away from the electrically insulating carrier 1. It should be noted that the leadframe 53 and the legs 52 each include a conventional electrically conducting material.

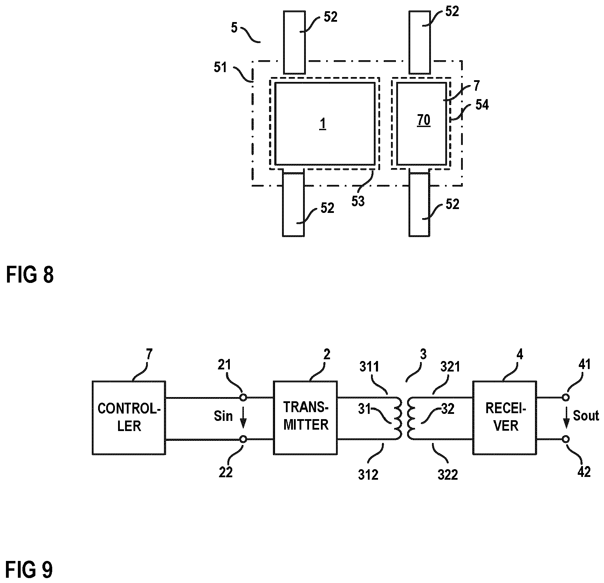

Figure 8 shows a transformer arrangement according to another example. In this example, the transformer arrangement includes a further integrated circuit 7 with a further semiconductor die 70. The further semiconductor die 70 is spaced apart from the electrically insulating carrier 1 and is embedded in the package body 51. Optionally, in the same way as explained with reference to Figures 7A-7B, the electrically insulating carrier 1 is carried by a leadframe 53. Optionally, the further semiconductor die 70 is carried by a further leadframe 54 that is spaced apart from the optional leadframe 53 carrying the electrically insulating carrier 1. One of the legs 52 protruding from the package body 51 may be connected to the further leadframe 54.

Figure 9 shows an equivalent circuit diagram of an electronic circuit that includes a transformer arrangement of the type illustrated in Figure 8. The electronic circuit according to Figure 9 is based on the electronic circuit according to Figure 5 and includes a transmitter included in the first integrated circuit 2, the transformer 3, and a receiver included in the second integrated circuit 4. Additionally, the electronic circuit includes a controller that is included in the further integrated circuit 7. The controller may provide the signal Sin that is to be transmitted across the transformer 3.

According to one example, the signal Sin provided by the controller 7 is a control signal for switching on or switching off a power transistor. In this example, the output signal Sout provided by the receiver 4 is received by a transistor driver that drives the power transistor based on the control signal Sin. According to one example (not illustrated), the driver and the power transistor are also embedded in the package body 51. The power transistor is integrated in a semiconductor die different from the semiconductor dies in which the first and second integrated circuits 2, 4 and the controller 7 are integrated. The power transistor and the driver may be integrated in separate semiconductor dies or may be integrated in the same semiconductor die.

Referring to the above, the first semiconductor die 2 and the first and second windings 31, 32 may be embedded in the electrically insulating carrier 1 or may be formed on top of the electrically insulating carrier 1. Various ways for embedding the first and second windings 31, 32 and the first semiconductor die 2 in the electrically insulating carrier 1 or for arranging the first and second windings 31, 32 and the first semiconductor die 2 on top of the electrically insulating carrier 1 are explained in the following. It should be noted that the optional second semiconductor die 40 may be embedded in or arranged on top of the electrically insulating carrier 1 in accordance with any of the examples explained below with reference to embedding the first semiconductor die 2 in the electrically insulating carrier 1 or with reference to arranging the first semiconductor die 2 on top of the electrically insulating carrier 1. Furthermore, it should be noted that in the same arrangement 1 one of the components (first or second semiconductor die 20, 40, first or second winding 31, 32) may be embedded in the electrically insulating carrier 1 and another one of the components may be arranged on top of the electrically insulating carrier 1.

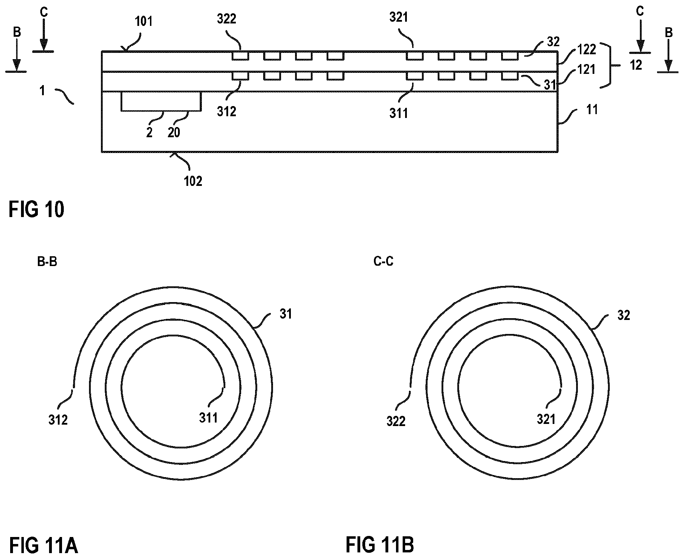

Figure 10 illustrates one example in which the first integrated circuit 2 and the first and second windings 31, 32 are embedded in the electrically insulating carrier 1. Figure 10 shows a vertical cross-sectional view of the electrically insulating carrier 1 with the first integrated circuit 2 and the first and second windings 31, 32 embedded therein. In this example, the electrically insulating carrier 1 includes an insulating core layer 11 (which may also be referred to as the base layer 11) and an insulating layer 12 formed on top of the core layer 11. In this example, the semiconductor die 20 of the first integrated circuit 2 is embedded in the core layer 11 and the first and second windings 31, 32 are embedded in the insulating layer 12 formed on top of the core layer 11. According to one example, the core layer 11 includes a mold compound. Furthermore, the insulating layer 12 may include at least one of a polyimide; an epoxy; an oxide, such as silicon oxide; a nitride, such as silicon nitride; or a ceramic, in particular a high-k ceramic, such as BaTiOx, AlOx, or the like.

Referring to Figure 10, the insulating layer 12 may include a first partial layer 121 in which the first winding 31 is embedded, and a second partial layer 122 in which the second windings 32 is embedded. The first and second windings 31, 32 are separated from each other by portions of at least one of the first and second partial layers 121, 122.

Referring to Figure 10, each of the first and second windings 31, 32 is a planar winding, which is a winding that is formed in a horizontal plane of the insulating carrier 1 that is essentially parallel to first and second surface is 101, 102 of the carrier 1. In the example illustrated in Figure 10, the first surface 101 is a surface formed by the insulating layer 12 and the second surface 102, which is opposite the first surface 101, is formed by the core layer 11.

Furthermore, each of the first and second windings 31, 32 includes a conductor arranged in such a way that several turns of the respective winding 31, 32 is formed. Top views of the first and second windings 31, 32 are schematically illustrated in Figures 11A-11B. Forming each of the first and second windings 31, 32 may include forming a trench in the respective partial layer 121, 122 and filling the trench with an electrically conducting material. Examples of the electrically conducting material include, but are not restricted to, aluminum (Al), copper (Cu), silver (Ag), or alloys including one or more of these materials.

The first and second windings 31, 32 are formed one above the other, but separated from one another by portions of the electrically insulating carrier 1, in order to provide for an inductive coupling between the first and second windings 31, 32. This is basically known in a coreless transformer, so that no further explanation is required in this regard.

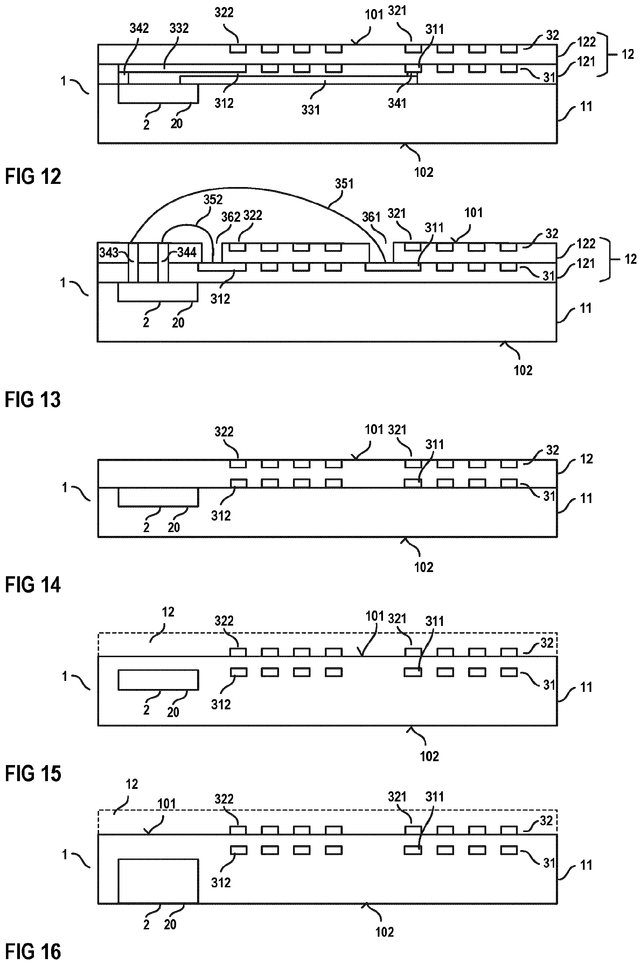

Figure 10 schematically illustrates how the first and second windings 31, 32 and the first semiconductor die 20 can be arranged in the electrically insulating carrier 1. Connections between one of the first and second windings 31, 32 and the semiconductor die 20 are not illustrated in Figure 10. Such connections may be implemented in various ways. Two examples are explained with reference to Figures 12 and 13 in the following. In these examples, the first winding 31 is connected to the first semiconductor die 20. This, however, is only an example. It is also possible to connect the second winding 32 to the first semiconductor die 20.

Referring to Figure 12, which shows a vertical cross-sectional view of the insulating carrier 1, connections between the first winding 31 and the first semiconductor die 20 are integrated in the insulating carrier 1. More specifically, in this example, the connections include a first conductor 331 that connects the first terminal 311 of the first winding 31 to the first semiconductor die 20, and a second conductor 332 that connects the second terminal 312 of the first winding 31 to the first semiconductor die 20. Just for the purpose of explanation, both conductors 331, 332 are arranged in the first partial layer 12 at different vertical positions of the first partial layer 12 and laterally extend from the respective first or second terminal 311, 312 of the first winding 31 to the first semiconductor die 20. The "vertical position" is a position in a vertical direction of the insulating layer 1. The "vertical direction" is a direction that is essentially perpendicular to first and second surfaces of the insulating carrier 1. To "laterally extend" includes to extend in a lateral direction of the insulating carrier 1. The "lateral direction" is a direction that is substantially parallel to the first and second surfaces 101, 102 of the insulating carrier 1.

Referring to Figure 12, in addition to the first and second conductors 331, 332, the connections may include one or more electrically conducting vias 341, 342. In the example according to Figure 12, the connections include a first electrically conducting via 341 that connects the first conductor 331 to the first terminal 311 of the first winding 31 and a second electrically conducting via 342 that connects the second conductor 332 to the first semiconductor die 20. In this example, the first conductor 331 is directly connected to the first semiconductor die 20 and the second conductor is 332 is directly connected to the first winding 31. This, however, is only an example. It is also possible to connect at least one of the two conductors 331, 332 through one electrically conducting via to the first winding 31 and through another electrically conducting via to the first semiconductor die 20. The conductors 331, 332 and the vias 341, 342 each include an electrically conducting material that may be selected from the same group of materials that may be used for implementing the first and second windings 31, 32.

In the example according to Figure 13, bond wires 351, 352 connect the first and second terminals 311 of the first winding 31 to the first semiconductor die 20. In this example, each of the first semiconductor die 20 and the first winding 31 is spaced apart from the first surface 101. Thus, for connecting the bond wires 351, 352 to the first semiconductor die 20 the transformer arrangement includes electrically conducting vias 343, 344 that extend from the first semiconductor die 20 to the first surface 101 where the bond wires 351, 352 are connected to the vias 343, 344. For connecting the bond wires 351, 352 to the first and second terminals 311, 312 of the first winding 31 the transformer arrangement includes openings 361, 362 in the first partial layer 122. These openings extend from the first surface 101 through the second partial layer 122 to the first and second terminals 311, 312 of the first winding 31. The bond wires 351, 352 are connected to the first and second terminals 311 of the first winding 31 within the openings 361, 362.

As can be seen from Figure 13, vias 343, 344 and openings 361, 362 are means for connecting the bond wires 351, 352 to the first winding 31 and the first semiconductor die 20 that are each spaced apart from the first surface 101. The specific implementation illustrated in Figure 13, however, is only an example. It would also be possible to provide openings above the second semiconductor die 20 and vias above the first and second Terminals 311, 312. Furthermore, it would also be possible to either only use vias, or only use openings for connecting the bond wires 351, 352 to the first winding 31 and the first semiconductor die 20.

Referring to Figure 13, the second winding 32 adjoins the first surface 101. According to one example (not illustrated), the second winding 32 is connected to the first semiconductor die 20. In this example, the bond wires 351, 352 may directly be connected to the second winding 32, so that no vias or openings are required.

In the examples illustrated in Figures 10 and 12-13 the first semiconductor die 20 is integrated in the core layer 11 and the first and second windings 31, 32 are integrated in the insulating layer 12 formed on top of the core layer 11. This, however, is only one of various examples for embedding the semiconductor die 20 and the first and second windings 31, 32 of the transformer in the insulating layer 11. Further examples are explained in the following. It should be noted that these examples illustrate ways for embedding the first semiconductor die 20 and the first and second windings 31, 32 in the insulating layer 1. Connections between one of the windings 31, 32 and the first semiconductor die 20 are not illustrated. These connections may implemented in various ways. In particular, these connections may include lateral conductors as illustrated in Figure 12 or bond wires as illustrated in Figure 13, wherein lateral conductors and bond wires may be combined with electrically conducting vias.

In the examples illustrated in Figures 12 and 13, the first winding 31 is spaced apart from the core layer 11. This, however, is only an example.

According to another example illustrated in Figure 14, the first winding 31 is integrated in the insulating layer 12 and formed on top of the core layer 11. The second winding 32 is spaced apart from the first winding 31 in the vertical direction of the insulating carrier and is also integrated in the insulating layer 12. The first semiconductor die 20 is embedded in the core layer 11 in the example illustrated in Figure 14.

According to another example illustrated in Figure 15, the first winding 31 is embedded in the core layer 11 and the second winding 32 is formed on top of the first surface 101 of the insulating carrier 1. In the example according to Figure 15, the first surface 101 of the insulating carrier 1 is formed by a surface of the core layer 11. The first semiconductor die 20 is embedded in the core layer 11 in this example. The semiconductor die 20 may be arranged spaced apart from the first surface 101 (as illustrated) or may adjoin the first surface 101 (not illustrated).

Optionally, in the examples illustrated in Figures 15 and 16, the second winding 32 formed on top of the surface of the core layer 11 is covered by insulating layer 20 (illustrated in dashed lines in Figures 15 and 16) so that the second winding 32 is embedded in the optional insulating layer 12.

Figure 16 illustrates a modification of the transformer arrangement according to Figure 15. In the example illustrated in Figures 16, the first semiconductor die 20 is embedded in the core layer 11 and adjoins the second surface of the core layer 11. The second surface is opposite the first surface on top of which the second winding 32 is formed. In this example, the second surface of the core layer 11 forms the second surface 102 of the insulating carrier 1.

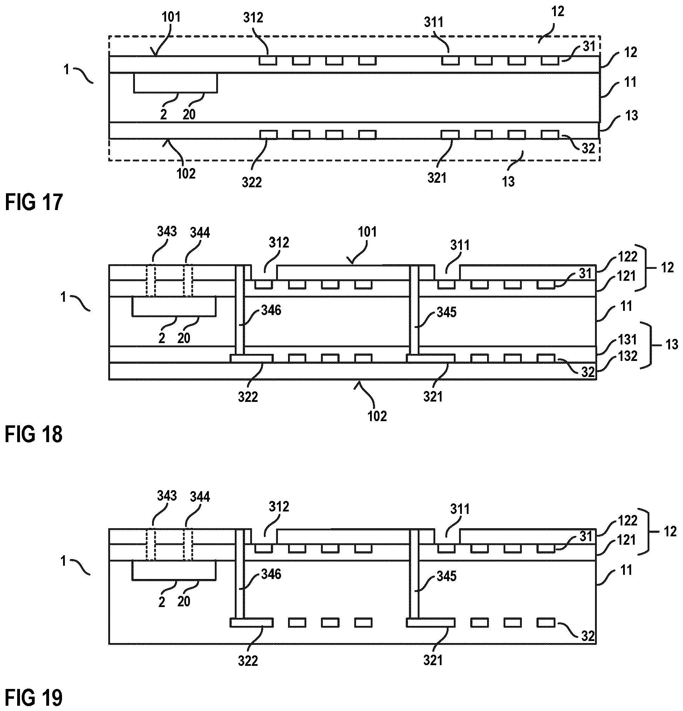

Figure 17 shows a vertical cross-sectional view of a transformer arrangement according to another example. In this example, the first winding 31 is embedded in a first insulating layer 12 formed on top of a first surface of the core layer 11, and the second winding 32 is embedded in a second insulating layer 13 formed on top of a second surface of the core layer 11. The second surface of the core layer 11 is opposite the first surface. The semiconductor die 20 is embedded in the core layer 11 in this example.

Referring to Figure 17, the first winding 31 may be embedded in the first insulating layer 12 such that the first winding 31 extends to a surface of the first insulating layer 12. In this example, the surface of the insulating layer 12 forms the first surface 101 of the insulating carrier 1. Equivalently, the second winding 32 may be embedded in the second insulating layer 13 such that the second winding 32 extends to a surface of the second insulating layer 13. In this example, the surface of the second insulating layers 13 forms the second surface 102 of the insulating carrier 1.

According to another example illustrated in dashed lines in Figure 17, the first winding 31 is embedded in a first partial layer of the first insulating layer and a second partial layer is formed on top of the first partial layer, so that the first winding 31 is spaced apart from the surface of the first insulating layer 12. The second partial layer of the first insulating layer 12 is illustrated in dashed lines in Figure 17. Equivalently, the second insulating layer 13 may include a first partial layer in which the second winding 32 is embedded and a second partial layer that covers the first partial layer and forms the second surface of the insulating carrier 1. The second partial layer of the second insulating layer 13 is illustrated in dashed lines in Figure 17.

Figure 18 illustrates a transformer arrangement of the type illustrated in Figure 17 in greater detail. In this example, the first insulating layer 12 includes a first partial layer 121 in which the first winding 31 is embedded, and a second partial layer 122 covering the first partial layer 121. Equivalently, the second insulating layer 13 includes a first partial layer 131 in which the second winding 32 is embedded, and a second partial layer 132 covering the first partial layer 131. The first semiconductor die 20 is embedded in the core layer 11 in this example.

In the example according to Figure 18, the first and second windings 31, 32 can be contacted via the first surface 101 of the insulating carrier 1. For this, electrically conducting vias 345, 346 connected to the first and second terminals 321, 322 of the second winding 32 extend, in the vertical direction of the insulating carrier 1, to the first surface 101. The first and second terminals 311, 312 of the first winding 31 are accessible through openings in the second partial layer 122 of the first insulating layer 12. For contacting the semiconductor die 20 electrically conducting vias 343, 344 may extend from the first semiconductor die 20 to the first surface 101. In order to connect one of the first and second windings 31, 32 to the first semiconductor die 20, one of the first and second windings 31, 32 may be connected to the vias 343, 344 through bond wires (not illustrated), for example.

Figure 19 shows a modification of the arrangement according to Figure 18. In the example illustrated in Figure 19, the second winding 32 is embedded in the core layer 11. The second insulating layer 13 formed on top of the second surface of the core layer 11 is omitted in the example according to Figure 19.

Referring to the above, the insulating carrier 1 may include a core layer 11 that includes or is comprised of a mold compound. In this example, the first semiconductor die 20 and, optionally, at least one of the first and second windings 31, 32 can be in embedded in the core layer 11 using a molding process. However, the core layer 11 is not restricted to include a mold compound. Other electrically insulating materials may be used as well. According to example, the core layer is a glass layer.

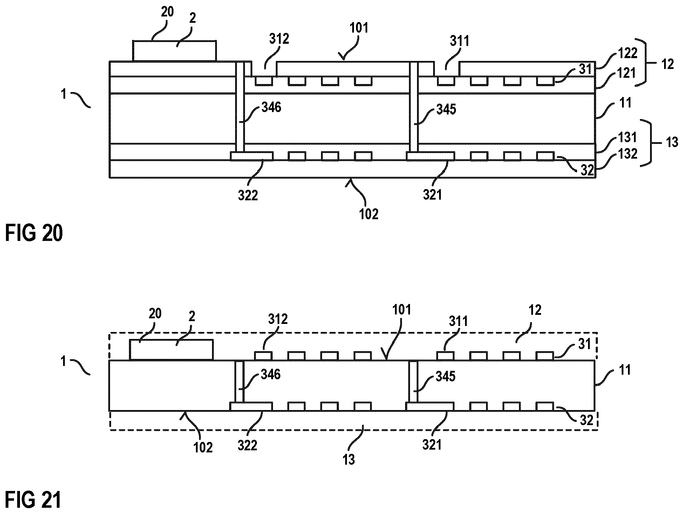

Figure 20 shows a vertical cross-sectional view of a transformer arrangement that includes an electrically insulating carrier 1 with a core layer 11 including glass. In the transformer arrangement according to Figure 20, the first and second windings 31, 32 are formed similar to the arrangement illustrated in Figure 18. That is, the first winding 31 is embedded in a first insulating layer 12 that is formed on top of a first surface of the core layer 11, and the second winding 32 is embedded in a second insulating layer 32 that is formed on top of a second surface opposite the first surface of the core layer 11. Different from the example illustrated in Figure 18, the first semiconductor die 20 is not embedded in the core layer 11 but is formed on top of the first insulating layer 12.

The first semiconductor die 20 may be connected to one of the first and second windings 31, 32 using bond wires (not illustrated in Figure 20). Like in the example according to Figure 18, electrically conducting vias may extend through the core layer 11 from the second winding 32 to the surface of the first insulating layer 12. The surface of the first insulating layer 12 forms the first surface 101 of the insulating carrier 1 in this example.

The first and second insulating layers 12, 13 illustrated in Figure 20 may include the same type of material as explained herein above with regard to the first and second insulating layers 12, 13 formed on top of a core layer 11 including a mold compound.

Figure 21 illustrates another example of a transformer arrangement including an insulating carrier 1 with a core layer 11 of glass. In this example, the first semiconductor die 20 and the first winding are formed on top of the first surface of the core layer 11, and the second winding 32 is embedded in the core layer 11 in the second surface opposite the first surface. Forming the second winding 32 embedded in the core layer in the second surface 102 may include etching a trench in the second surface 102 of the core layer 11 and filling the trench with an electrically conducting material. Optionally, a first insulating layer 12 (illustrated in dashed lines) covers the first semiconductor die 20 and the first winding 31 formed on top of the core layer 11, so that the first semiconductor die 20 and the first winding 31 are embedded in the insulating layer 12. Equivalently, a second insulating layer 13 (illustrated in dashed lines) may be formed on top of the second surface of the core layer 11 and cover the second winding 32.

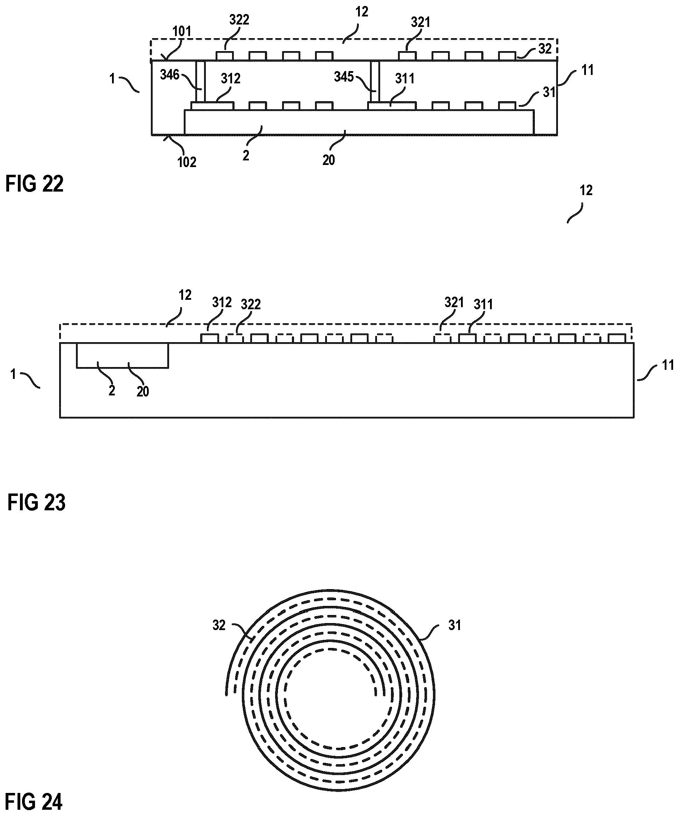

Figure 22 illustrates a transformer arrangement according to another example. In this example, the first winding 31 is formed on top of the first semiconductor die 20 and the arrangement including the first semiconductor die 20 and the first winding 31 is embedded in the core layer 11. The first semiconductor die 20 the first winding 31 may completely be embedded in the core layer 11. Alternatively, as illustrated, the first semiconductor die 20 may not be covered by the core layer 11 in the region of one surface of the core layer 11. In the example illustrated in Figure 22, the first semiconductor die 20 is not covered by the core layer 11 in the region of a second surface 102 of the insulating carrier 1. The second surface 102 of the insulating carrier 1 is formed by the second surface of the core layer 11 in this example.

Referring to Figure 22, the second winding 32 is formed on top of the first surface of the core layer 11 and is spaced apart from the first winding 31 in the vertical direction of the insulating layer 1. Optionally, the second winding 32 formed on top of the first surface of the core layer 11 is covered by an insulating layer 12 (illustrated in dashed lines), so that the second winding 32 is embedded in the insulating layer 12. The core layer 11 includes a mode compound, for example.

In the examples of the transformer arrangement explained before, the first and second windings 31, 32 are arranged in different horizontal planes of the electrically insulating carrier 1, so that the first and second windings 31, 32 are spaced apart from each other in the vertical direction of the electrically insulating layer 1.Referring to the above, the "vertical direction" is a direction perpendicular to the first and second surfaces 101, 102. Arranging the first and second windings 31, 32 in this way, however, is only an example.

According to another example illustrated in Figure 23, the first and second windings 31, 32 are formed in the same horizontal plane of the insulating carrier 1. Just for the purpose of illustration, in the example illustrated in Figure 23, the first and second windings 31, 32 are formed on top of a surface of the core layer 11. To ease understanding, the first winding 31 is illustrated in solid lines and the second windings 32 is illustrated in dashed lines in Figure 23. Figure 24 shows a top view of the first and second windings 31, 32. As can be seen from Figure 24, the first and second windings 31, 32 have the same shape and are wound essentially parallel with each other.

In the example illustrated in Figure 23, the first semiconductor die 20 is embedded in the core layer 11. This, however, is only an example. It is also possible to form the first semiconductor die 20 on top of the core layer 11. Furthermore, in addition to the core layer 11, the transformer arrangement may include an insulating layer 12 (illustrated in dashed lines) covering the first and second windings 31, 32. Moreover, forming the first and second windings on top of the core layer 11, as illustrated in Figure 23, is only an example. It is also possible to embed the first and second windings 31, 32 in an insulating layer formed on top of the core layer 11 in the same way as explained hereinabove with regard to the first winding 31 and/or the second winding 32.

In the example illustrated in Figure 23, the core layer 11 is a mold compound. This, however, is only an example. It is also possible to implement the core layer 11 as a glass layer. In this example, the semiconductor die 20 may be formed on top of the core layer 11.

In the transformer arrangement explained with reference to Figures 10 et seq. only the first semiconductor die 20 is illustrated to be embedded in the insulating carrier 1 or formed on top of the insulating carrier 1. It should be noted that this is only an example. In the same way as the first semiconductor die 20 is embedded in or formed on top of the insulating carrier 1 one or more additional semiconductor dies, such as the second semiconductor die 40 explained hereinabove, may be embedded in or formed on top of the electrically insulating carrier 1.

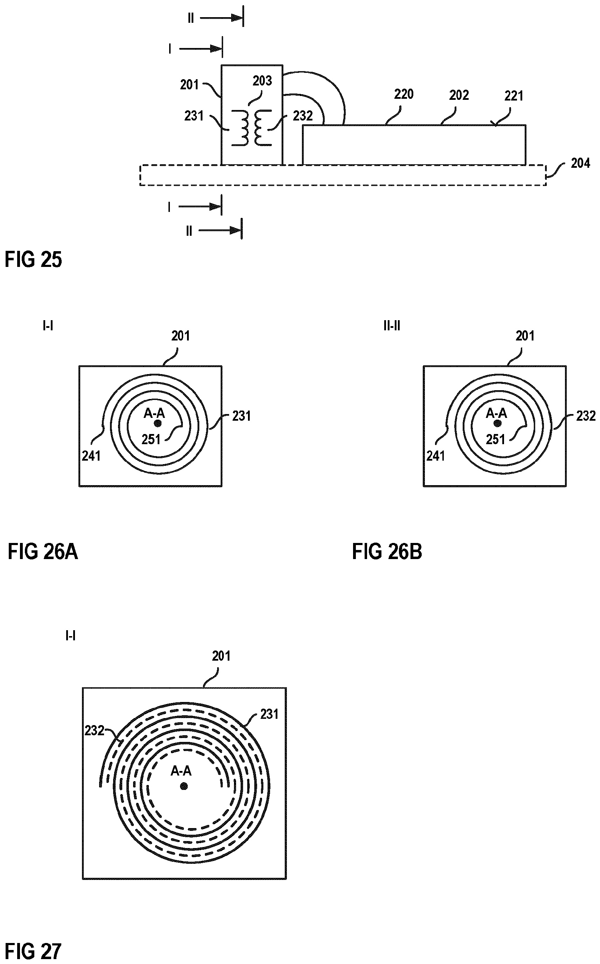

Figure 25 schematically illustrates a transformer arrangement according to another example. The transformer arrangement includes an electrically insulating body 201 and a transformer 203 with a first winding 231 and a second winding 232 that are at least partially embedded in the electrically insulating body 201. The electrically insulating body 201 includes a mold compound, for example. The transformer 203 is only schematically illustrated in Figure 25. Examples for at least partially embedding the transformer 203 in the electrically insulating body 201 are explained herein further below.

Referring to Figure 25, the transformer arrangement further includes an integrated circuit 202 with a semiconductor die 220. The integrated circuit 202 is connected to one of the first and second windings 231, 232 of the transformer 203. Connections between the integrated circuit 202 and the one of the first and second windings 231, 232 are only schematically illustrated in Figure 25. These connections may be implemented in a conventional way using bond wires, for example.

Both the semiconductor die 220 of the integrated circuit 202 and the electrically insulating body 201 may be arranged on top of a carrier 204 (illustrated in dashed lines in Figure 25). The carrier is a PCB (printed circuit board), for example.

Referring to Figure 25, the semiconductor die 20 has a first surface 221, which may be a surface of the semiconductor die 220 facing away from the carrier 204. According to one example, the first and second winding 231, 232 are formed in the insulating body 201 such that each of the first and second windings are wound around an imaginary axis A-A. Each of the first and second windings 231, 232 may be implemented as a planner winding. In this case, the imaginary axis A-A is perpendicular to the respective horizontal plane in which the respective one of the first and second windings 231, 232 is formed. The electrically insulating body 201 is oriented relative to the semiconductor die 220 such that the imaginary axis A-A of the first and second transformer windings 231, 232 is essentially (at least approximately) parallel to the first surface 221 of the semiconductor die 220. In this way, the arrangement with the semiconductor die 220 and the insulating body 201 including the transformer 203 can be implemented to have a small footprint.

Figures 26A-26B schematically illustrate one example of the transformer 203. More specifically, Figure 26A shows a vertical cross-sectional view of the insulating body 201 in a section plane I-I in which the first winding 231 is formed, and Figure 26B shows a vertical cross-sectional view of the insulating body 201 in a section plane II-II in which the second winding 232 is formed. In this example, each of the first and second windings 231, 232 is a planar winding. The planes of the insulating body 201 in which the first and second windings 231, 232 are formed are perpendicular to the first surface 221 of the semiconductor die 220, so that the imaginary axis A-A around which the turns of the first and second windings 231, 2032 are wound are essentially parallel to the first surface 221.

In the example illustrated in Figures 26A-26B the first and second windings are spaced apart from each other, wherein the planes in which the two windings 231, 2032 are formed are essentially parallel with each other. Implementing the first and second windings in different planes, however, is only an example.

Figure 27 illustrates a transformer with a first and a second winding 231, 232 according to another example. In this example, the first and second windings 231, 232 are formed in the same plane of the insulating body 201 and turns of the first and second winding 231, 2032 are wound around the same imaginary axis A-A'.

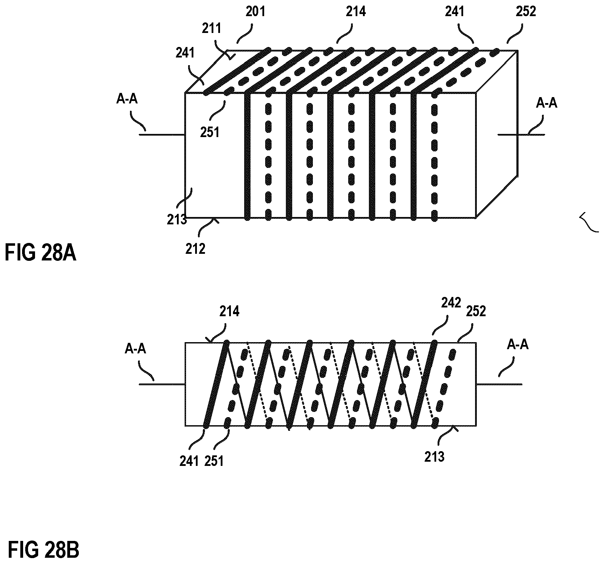

Figures 28A-28B illustrate another example of a transformer with a first winding 231 and a second winding 232 that are each wound around the same imaginary axis A-A. Each of Figures 28A-28B shows a portion of the insulating body 201 in which the first and second windings 231, 232 are embedded. The first winding 231 is schematically illustrated by a bold solid line and the second winding 232 is schematically illustrated by a dashed solid line in Figures 28A-28B. Figure 28A shows a perspective view of one portion of the solid body 201 and Figure 28B shows a top view of a first plane 211 of that portion of the solid body 201.

Referring to Figures 28A-28B, each of the first and second windings 231, 232 winds around the imaginary axis A-A in a spiral fashion. Each of the first and second windings 231, 232 has a plurality of winding sections that are parallel with each other and parallel with respective winding sections of the other one of the first and second windings 231, 232. A first group of these winding sections is formed in a first plane 211 of the insulating body 21, and a second group of these winding sections is formed in a second plane 212 parallel to the first plane 211. Furthermore, winding sections in the first and second planes 211, 212 of each of the first and second windings 231, 232 are connected by winding sections arranged in third and fourth planes 213, 214 which are perpendicular to the first and second planes 211, 212. Winding sections of the first and second windings 231, 232 that are formed in the second plane are illustrated in thin lines in Figure 28B.

Some of the aspects explained above a briefly summarized in the following with reference to numbered examples.

Example 1. A transformer arrangement including: an electrically insulating carrier; a first integrated circuit including a first semiconductor die embedded in or arranged on top of the electrically insulating carrier; and a transformer including a first winding and a second winding that are inductively coupled, wherein one of the first and second windings is connected to the first integrated circuit, and wherein each of the first and second windings is embedded in or arranged on top of the electrically insulating carrier.

Example 2. The transformer arrangement of example 1, further including: a second integrated circuit including a second semiconductor die embedded in or arranged on top of the electrically insulating carrier, wherein the other one of the first and second windings is connected to the second integrated circuit.

Example 3. The transformer arrangement of example 1 or 2, wherein the first integrated circuit includes one of a transmitter circuit and a receiver circuit.

Example 4. The transformer arrangement of example 3, wherein the second integrated circuit includes the other one of the transmitter circuit and the receiver circuit.

Example 5. The transformer arrangement of any one of the preceding examples, further including: a package including a package body and a plurality of legs protruding from the body, wherein the electrically insulating carrier is embedded in the package body.

Example 6. The transformer arrangement of example 5, further including: a further semiconductor die embedded in the package body spaced apart from the electrically insulating carrier.

Example 7. The transformer arrangement of any one of examples 1 to 6, wherein the first winding is arranged in a first horizontal plane of the electrically insulating layer, wherein the second winding is arranged in a second horizontal plane of the electrically insulating layer, and wherein the first horizontal plane is spaced apart from the second horizontal plane in a vertical direction of the electrically insulating layer.

Example 8. The transformer arrangement of any one of examples 1 to 6, wherein the first winding and the second winding are arranged in a same horizontal plane of the electrically insulating layer.

Example 9. The transformer arrangement of any one of examples 1 to 8, wherein the electrically insulating layer includes a core layer and a first insulating layer formed on top of a first surface of the core layer, and wherein at least one of the first winding and the second winding is embedded in the first insulating layer.

Example 10. The transformer arrangement of example 9, wherein each of the first winding and the second winding is embedded in the first insulating layer.

Example 11. The transformer arrangement of example 9, wherein the electrically insulating layer includes a second insulating layer formed on top of a second surface opposite the first surface of the core layer, and wherein the other one of the first winding and the second winding is embedded in the second insulating layer.

Example 12. The transformer arrangement of example 9, wherein the other one of the first winding is embedded in the core layer.

Example 13. The transformer arrangement of any one of examples 9 to 12, wherein the core layer includes a mold compound, and wherein the first semiconductor die is embedded in the core layer.

Example 14. The transformer arrangement of any one of examples 9 to 11, wherein the core layer includes a glass, and wherein the first semiconductor die is formed on top of the core layer.

Example 15. The transformer arrangement of any one of examples 1 to 8, wherein the electrically insulating layer includes a core layer including a mold compound, wherein at least one of the first and second windings is embedded in the core layer.

Example 16. The transformer arrangement of any one of examples 1 to 8, wherein the first semiconductor die is embedded in the electrically insulating layer, and wherein at least one of the first and second windings is formed on top of the first semiconductor die.

Example 17. The transformer arrangement of any one of examples 1 to 16, wherein the one of the first and second windings that is connected to the first integrated circuit is connected to the first integrated circuit through bond wires.

Example 18. The transformer arrangement of any one of examples 1 to 16, wherein the one of the first and second windings that is connected to the first integrated circuit is connected to the first integrated circuit through connections arranged within the electrically insulating layer.

Example 19. A transformer arrangement, including: an integrated circuit including a semiconductor die having a first surface; and a transformer with a first winding and a second winding that are at least partially embedded in an electrically insulating body, wherein each of the first and second windings is wound around an imaginary axis that is at least approximately parallel to the first surface of the semiconductor die.

## Claims

1. A transformer arrangement comprising:
an electrically insulating carrier (1);
a first integrated circuit (2) comprising a first semiconductor die (20) embedded in or arranged on top of the electrically insulating carrier (1); and
a transformer (3) comprising a first winding (31) and a second winding (32) that are inductively coupled,
wherein one of the first and second windings (31, 32) is connected to the first integrated circuit (2), and
wherein each of the first and second windings (31, 32) is embedded in or arranged on top of the electrically insulating carrier (1).

2. The transformer arrangement of claim 1, further comprising:
a second integrated circuit (4) comprising a second semiconductor die (40) embedded in or arranged on top of the electrically insulating carrier (1),
wherein the other one of the first and second windings (31, 32) is connected to the second integrated circuit (4).

3. The transformer arrangement of claim 1 or 2,
wherein the first integrated circuit (2) comprises one of a transmitter circuit and a receiver circuit.

4. The transformer arrangement of any one of the preceding claims, further comprising:
a package (5) comprising a package body (51) and a plurality of legs (52) protruding from the body (51),
wherein the electrically insulating carrier (1) is embedded in the package body (51).

5. The transformer arrangement of claim 4, further comprising:
a further semiconductor die (70) embedded in the package body (51) spaced apart from the electrically insulating carrier (1).

6. The transformer arrangement of any one of claims 1 to 5,
wherein the first winding (31) is arranged in a first horizontal plane of the electrically insulating layer (1),
wherein the second winding (31) is arranged in a second horizontal plane of the electrically insulating layer (1), and
wherein the first horizontal plane is spaced apart from the second horizontal plane in a vertical direction of the electrically insulating layer (1).

7. The transformer arrangement of any one of claims 1 to 5,
wherein the first winding (31) and the second winding (32) are arranged in a same horizontal plane of the electrically insulating layer (1).

8. The transformer arrangement of any one of claims 1 to 7,
wherein the electrically insulating layer (1) comprises a core layer (11) and a first insulating layer (12) formed on top of a first surface of the core layer (11), and
wherein at least one of the first winding (31) and the second winding (32) is embedded in the first insulating layer (12).

9. The transformer arrangement of claim 8,
wherein the electrically insulating layer (1) comprises a second insulating layer (13) formed on top of a second surface opposite the first surface of the core layer (11), and
wherein the other one of the first winding (31) and the second winding (32) is embedded in the second insulating layer (13).

10. The transformer arrangement of claim 8,
wherein the other one of the first winding (31 and the second winding (32) is embedded in the core layer (11).

11. The transformer arrangement of any one of claims 8 to 10,
wherein the core layer (11) comprises a mold compound, and
wherein the first semiconductor die (20) is embedded in the core layer (11).

12. The transformer arrangement of any one of claims 8 to 9,
wherein the core layer (11) comprises a glass, and
wherein the first semiconductor die (20) is formed on top of the core layer (11).

13. The transformer arrangement of any one of claims 1 to 7,
wherein the electrically insulating layer (1) comprises a core layer (11) comprising a mold compound,
wherein at least one of the first and second windings (31) is embedded in the core layer.

14. The transformer arrangement of any one of claims 1 to 7,
wherein the first semiconductor die (20) is embedded in the electrically insulating layer (1), and
wherein at least one of the first and second windings (31, 32) is formed on top of the first semiconductor die (20).

15. The transformer arrangement of any one of claims 1 to 14,
wherein the one of the first and second windings (31, 32) that is connected to the first integrated circuit (2) is connected to the first integrated circuit (2) through bond wires (351, 352) or through connections (331, 332, 341, 342) arranged within the electrically insulating layer (1).
